Europäisches Patentamt

European Patent Office

Office européen des brevets

(11) Veröffentlichungsnummer: **0 494 415 A2**

## EUROPÄISCHE PATENTANMELDUNG

(21) Anmeldenummer: **91121760.2**

(22) Anmeldetag: **19.12.91**

(51) Int. Cl.⁵: **G11C 13/02**

(30) Priorität: **07.01.91 DE 4100254**

(43) Veröffentlichungstag der Anmeldung:
**15.07.92 Patentblatt 92/29**

(84) Benannte Vertragsstaaten:
**AT BE CH DE ES FR GB IT LI NL SE**

(71) Anmelder: **BASF Aktiengesellschaft
Carl-Bosch-Strasse 38
W-6700 Ludwigshafen(DE)**

(72) Erfinder: **Fuchs, Harald, Dr.
Boehlweg 32
W-6719 Carlsberg(DE)**
Erfinder: **Schimmel, Thomas, Dr.
Eppenreuther Strasse 8
W-8670 Hof(DE)**

(54) **Verfahren zur chemischen Markierung von Festkörperoberflächen auf atomarer Skala sowie Verwendung dieses Verfahrens zur Speicherung von Informationseinheiten im atomaren Bereich.**

(57) Die Erfindung betrifft ein Verfahren zur gezielten, ortsselektiven und zeitlich stabilen Markierung von einzelnen atomaren Positionen oder von Gruppen solcher Positionen auf einer Festkörperoberfläche durch chemische Reaktion mit Fremdatomen bzw. Fremdmolekülen bzw. durch Chemisorption wobei jeweils die laterale atomare Ordnung der Festkörperoberfläche auch lokal erhalten bleibt, sowie die Verwendung dieses Verfahrens zur reversiblen Speicherung von Informationseinheiten.

Abb. 1

Die Erfindung betrifft ein verfahren zur gezielten, ortsselektiven und zeitlich stabilen Markierung von einzelnen Atomen oder von Gruppen von Atomen einer Festkörperoberfläche durch chemische Reaktion von Fremdatomen oder Fremdmolekülen mit der Festkörperoberfläche.

Die Speicherung von Informationen, insbesondere von Bild- und Datensignalen, erfolgt derzeit vorwiegend mit Hilfe magnetischer und optischer Aufzeichnungsträger. Die erzielbare Informationsdichte bei derartigen Aufzeichnungsträgern wird bestimmt durch die verfahrensbedingt kleinsten erzeugbaren und wieder auslesbaren Informationseinheiten. Diese sind bei den derzeit üblichen Magnetspeichern bestimmt durch die Größe der magnetischen Domänen (Weiß'sche Bezirke), in mechanischer Hinsicht durch den Kopfspalt der verwendeten Schreib/Leseköpfe sowie durch den Abstand der Schreib/Leseeinheit vom eigentlichen Informationsträger. Bei Informationsträgern, bei denen die eingespeicherte Information durch Änderung der optischen Eigenschaften erzeugt wird, liegt die Begrenzung in der verwendeten Lichtwellenlänge. Hier können somit die kleinsten Informationseinheiten nicht kleiner sein als etwa die halbe Lichtwellenlänge. Eine Steigerung der Speicherdichte bei derartigen optischen Aufzeichnungsträgern ist inzwischen auch durch die sogenannte optische Nahfeldmikroskopie erreichbar, wobei sich die optische Ausleseeinheit nur wenige Nanometer über der informationstragenden Oberfläche befindet. Erreicht werden hierbei Informationsdichten die sich bestenfalls in der Größenordnung von etwa 20 nm befinden.

Eine weitere Steigerung der Informationsdichte ist nur möglich durch die Anwendung von Nahfeldtechniken mit einer Auflösung im Subnanometerbereich. Hierzu eignen sich die sogenannten Raster-Sonden-Techniken zu denen das Raster-Tunnel-Mikroskop bzw. das Kraft-Mikroskop gehören. Diese Methoden erlauben Abbildungen von Oberflächen auf atomarer Skala. Es wurde daher schon vorgeschlagen, Informationsspeicher mit der höchstmöglichen Dichte, nämlich im Bereich der einzelnen Atome bzw. Moleküle, zu erzeugen. Die Realisierung dieser Speicher würde zu Informationsdichten führen, welche im Terabyte-Bereich pro cm$^2$ liegen.

Zur Speicherung von Informationen im Nanometerbereich auf anorganischen oder organischen Oberflächen gibt es bereits eine Reihe von Vorschlägen, so u.a. M.A. McCord et al., J.Vac.Sci.Technol. B4, 86-88 (1986), R.M. Silver et al., Appl.Phys.Lett. 51, 247-249 (1987), u. Staufer et al., J.Vac.Sci.Technol. A6, 537-539 (1988). Auch über die Abscheidung einzelner Atome wurde schon berichtet (R.S. Becker et al., Nature 325, 415-421 (1987)).

Alle bisher bekanntgewordenen Vorschläge, höchstauflösende Informationsspeicher, welche insbesondere auch über lange Zeit stabil sind, bereitzustellen, konnten jedoch nicht befriedigen. Während es bei den organischen Speichern noch nicht gelungen ist, Linienbreiten von <10 nm zu erzeugen war es bei anorganischen Systemen, welche Strukturen von bis herab zu 3 nm ergaben, nicht möglich, diese auch über längere Zeit, d.h. über Minuten bis zu Stunden, stabil zu halten. Bei den bis jetzt bekannt gewordenen Zeitlich stabilen Strukturen in Silicium (Appl.Phys.Lett. Van Loenen et al., (1989) 55, 1312-1314) wird dagegen die atomare Struktur zerstört, d.h. die atomare Ordnung geht verloren. Ein solches Verfahren eignet sich daher nur zur Erzeugung nichtlöschbarer Speicher.

Aufgabe der vorliegenden Erfindung war es daher, ein Verfahren bereitzustellen, das eine gezielte zeitlich stabile Markierung von Positionen auf einer Festkörperoberfläche auf atomarer Skala erlaubt, das somit die zeitlich stabile Speicherung von Informationen ermöglicht, ohne dabei das Gitter des Festkörpers lokal zu zerstören oder eine wesentliche Veränderung der Position der Gitterplätze parallel zur Festkörperoberfläche zu bewirken.

Es wurde nun gefunden, daß sich diese Aufgabe mit einem verfahren zur gezielten, ortsselektiven und zeitlich stabilen Markierung von einzelnen atomaren Positionen oder von Gruppen solcher Positionen auf einer Festkörperoberfläche durch chemische Reaktion von Fremdatomen und Fremdmolekülen mit der Festkörperoberfläche lösen läßt, wenn die Reaktion auf atomarer Skala gezielt mit Hilfe einer oberflächensensitiven Rastersonde bewirkt wird, mit der Maßgabe, daß die atomaren Gitterpositionen der oberen Atomlage parallel zur Festkörperoberfläche nicht wesentlich verändert oder Atome bzw. Moleküle aus zuvor besetzten Gitterpositionen nicht entfernt werden.

Das erfindungsgemäße Verfahren läßt sich insbesondere in der Weise durchführen, daß die lokale chemische Reaktion der Oberfläche mit den Fremdatomen oder Fremdmolekülen durch ein zeitlich und räumlich begrenztes elektrisches oder magnetisches Feld bewirkt wird.

Das erfindungsgemäße Verfahren der zeitlich stabilen Markierung von einzelnen Atomen oder Atomgruppen läßt sich in besonders vorteilhafter Weise für die Speicherung von Informationseinheiten heranziehen. Damit wird ein Weg aufgezeigt, die Speicherung von Informationen im atomaren Bereich vorzunehmen und somit die entsprechend hohe Informationsdichte zu erreichen.

Das erfindungsgemäße Verfahren läßt sich aber nicht nur für die Informationsspeicherung verwenden, es gestattet darüber hinaus auch ein Löschen der gespeicherten Informationen. Durch Zufuhr von Energie, etwa in Form thermischer Energie oder von elektromagnetischer Strahlung (z.B. flächige oder punktuelle Laserbehandlung), oder durch chemische Behandlung der Festkörperoberfläche läßt sich nämlich die chemische Bindung der Fremdatome oder Fremdmoleküle an die Festkörperoberfläche wieder aufbrechen und somit der ursprüngliche Zustand wiederherstellen, da das Gitter während des Markierungsprozesses auch lokal nicht zerstört wurde.

Das erfindungsgemäße Verfahren wird unter Anwesenheit des Reaktionspartners in ausreichender Konzentration - etwa als reaktive Atmosphäre oder in Form von an die zu modifizierende Oberfläche adsorbierten Fremdatomen oder Fremdmolekülen - durchgeführt. Als Festkörperoberflächen erwiesen sich halbleitende Schichtmaterialien, insbesondere Wolfram-Diselenid ($WSe_2$) als besonders geeignet. In der Oberfläche einer solchen Schicht wird nun mit Hilfe der Nahfeldtechnik, z.B. mittels einer nadelförmigen Elektrode einer oberflächensensitiven Rastersonde, etwa eines Raster-Tunnelmikroskops oder eines Rasterkraftmikroskops, durch Anlegen eines kurzzeitigen elektrischen oder magnetischen Feldes die atomare Markierung vorgenommen. Da der Ort des maximalen elektrischen Feldes einer solchen Rastersonde auf der Oberfläche des halbleitenden Schichtmaterials, vorzugsweise zwischen 10 nm und 0,1 nm beträgt, lassen sich damit gezielt einzelne Atome oder Atomgruppen beeinflussen. Das angelegte äußere Feld kann nun lokal auf atomarer Skala gezielt eine chemische Reaktion zwischen der Festkörperoberfläche und den Fremdatomen bzw. Fremdmolekülen auslösen. Wesentlich ist dabei, daß es bei dem erfindungsgemäßen Verfahren möglich ist, daß diese Reaktion mit der Festkörperoberfläche stattfindet, ohne daß dabei die Ordnung des Gitters der Festkörperoberfläche lokal in der Weise zerstört wird, daß dabei z.B. Atome oder Moleküle aus Gitterpositionen der Festkörperoberfläche entfernt werden; es ist dabei sogar möglich, eine Veränderung der Positionen der Gitterplätze parallel zur Festkörperoberfläche zu vermeiden.

Für die zum Einschreiben der Informationen verwendete Nahfeldtechnik lassen sich die bekannten Verfahren der Raser-Tunnel-Mikroskopie bzw. der Kraft-Mikroskopie einsetzen. Die Anordnung dieser Nahfeldtechniken ist zur charakterisierung von Oberflächen bekannt und auch beschrieben (Y. Kuk et al., Rev.Sci.Instrum. 60(2), 165-180 (1989)).

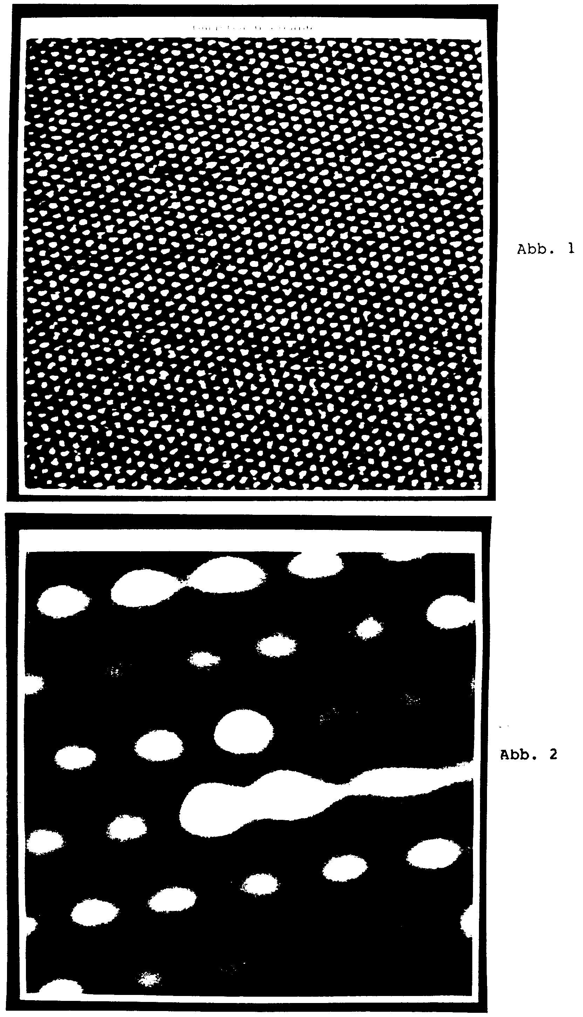

Das erfindungsgemäße Verfahren sei im folgenden beispielhaft erläutert:
Die Oberfläche einer Wolframdiselenid-Probe wurde mit einem Rastertunnelmikroskop zunächst mit atomarer Auflösung abgebildet. Danach wurden während des Rasterscans der Tunnelspitze über die Probe mittels eines Pulsgenerators in Überlagerung zur Tunnelspannung Spannungspulse mit einer Amplitude von 0,7 bis 0,9 Volt zwischen Tunnelspitze und Probe angelegt. Anschließendes Abscannen der Probe liefert Strukturen auf deren Oberfläche, die eine Markierung von atomaren Positionen klar erkennen lassen: die markierten Atome unterscheiden sich von ihren nicht markierten Nachbarn durch einen Anstieg in ihrer effektiven Höhe, der sich etwa in Abb. 2 in einer größeren Helligkeit der markierten Atompositionen im Vergleich zu ihren nicht markierten Nachbarn ausdrückt.

Der Markierungsprozeß sei anhand der Abbildungen 1 und 2 beispielhaft erläutert. Für das Experiment wurde Wolfram-Diselenid als Festkörperoberfläche und Luft als Reaktionsmedium verwendet. Um eine bessere Adsorption des Reaktionspartners an die Festkörperoberfläche zu gewährleisten, wurde statt einer frisch gespaltenen Probe eine Probe verwendet, deren Oberfläche vor dem Experiment für mehrere Wochen bei Raumtemperatur normaler Laborluft ausgesetzt war. Abb. 1 zeigt das mittels RTM aufgenommene Bild einer gewachsenen $WSe_2$-Oberfläche im unmodifizierten Zustand, Abb. 2 das Bild einer solchen Oberfläche unmittelbar nach Anwendung von Spannungspulsen von ca. 1.5 v. Die einzelnen Punkte in den Abbildungen stellen die Wolframatome der $WSe_2$-Oberfläche dar (Abstand zwischen benachbarten Atomen: 0.33 nm). Dreiergruppen von Atomen wurden hier gezielt verändert, wobei die relative Lage exakt den Positionen der Tunnelspitze zum Zeitpunkt des Pulses entspricht. Es ließen sich auf diese Weise Muster auf die Probe schreiben; jeder Spannungspuls markiert in definierter Position Atome, die sich nach der Modifikation nach wie vor an ihrer ursprünglichen lateralen Position befinden, wobei ihre Ladungsdichte jedoch durch die entstandene chemische Bindung mit dem Reaktionspartner verändert (im Beispiel von Abb. 2 erhöht) wurde.

Dabei war es problemlos möglich, mehr als 100 Strukturen mit der gleichen Spitze zu schreiben und anschließend atomar aufgelöst abzubilden. Veränderungen an der Abbildungsqualität der Probenspitze als Folge des Pulsens traten dabei normalerweise nicht auf. Sowohl der Schreib- als auch der Ausleseprozeß können unter normalen Bedingungen, d.h. insbesondere ohne Verwendung von Inertgas, Vakuum oder tiefen Temperaturen durchgeführt werden.

Um die Zeitstabilität der erzeugten Markierungen zu überprüfen, wurden gezielt bestimmte Anordnungen markierter Punkte, etwa im Dreieck oder als Parallelogramm, geschrieben und die resultierenden Strukturen abgebildet und in ihrer relativen Lage zueinander protokolliert; die Strukturen konnten in unveränderter Form und gleicher Anordnung nach zwei Tagen wieder aufgefunden werden. Inbesondere konnte dabei auch gezeigt werden, daß ihre Stabilität auch an Luft gegeben ist.

Für Anwendungen als Informationsspeicher ist es wesentlich, daß der Auslesevorgang die gespeicherten Informationen nicht verändert. Dazu wurden sowohl größere als auch kleinere Strukturen (Abb. 2) auf verschiedenen Wolframdiselenid-Proben über mehrere Stunden mit dem STM abgescannt und dabei bis zu 500 mal abgebildet. In keinem Fall konnte eine Veränderung durch den Abbildungsprozess (= Ausleseprozess bei der Anwendung als Datenträger) beobachtet werden.

Das Löschen von Strukturen auf Wolframdiselenid-Oberflächen erfolgte am einfachsten durch Erhitzen der Probenoberfläche für ca. 40 Minuten auf ca. 600°C. Auf der ganzen Oberfläche mit Strukturierungen bedeckte, aber nach wie vor atomar geordnete Oberflächen werden durch diesen Vorgang wieder atomar flach und strukturlos.

Für die Anwendung als Informationsspeicher wurden somit die Funktionen Lesen, Schreiben und Löschen anhand eines auf atomarer Skala ortsselektiven chemischen Verfahrens demonstriert und die zu ihrer Realisierung verwendeten Verfahren angegeben ("nanochemischer Speicher"); für die in Abb. 2 erzeugten Strukturen ergibt sich eine Datendichte von ca. 10 Terabyte/cm$^2$, was um einige Zehnerpotenzen die Speicherdichte von magnetischen Harddisks bzw. magnetooptischen Platten übersteigt.

**Patentansprüche**

1. Verfahren zur gezielten, ortsselektiven und zeitlich stabilen Markierung von einzelnen atomaren Positionen oder von Gruppen solcher Positionen auf einer Festkörperoberfläche durch chemische Reaktion von Fremdatomen oder Fremdmolekülen mit der Festkörperoberfläche, dadurch gekennzeichnet, daß die Reaktion auf atomarer Skala gezielt mit Hilfe einer oberflächensensitiven Rastersonde bewirkt wird, mit der Maßgabe, daß die atomaren Gitterpositionen der oberen Atomlage parallel zur Festkörperoberfläche nicht wesentlich verändert oder Atome bzw. Moleküle aus zuvor besetzten Gitterpositionen nicht entfernt werden.

2. Verfahren gemäß Anspruch 1, dadurch gekennzeichnet, daß als oberflächensensitive Sonde ein Rastertunnelmikroskop (RTM) eingesetzt wird.

3. Verfahren gemäß Anspruch 1, dadurch gekennzeichnet, daß als oberflächensensitive Sonde ein Raster-Kraft-Mikroskop (RKM) eingesetzt wird.

4. Verfahren gemäß Anspruch 1, dadurch gekennzeichnet, daß die lokale chemische Reaktion durch ein zeitlich und räumlich begrenztes elektrisches oder magnetisches Feld bewirkt wird.

5. Verfahren gemäß Anspruch 4, dadurch gekennzeichnet, daß das zeitlich und räumlich begrenzte elektrische Feld durch Anlegen eines Spannungspulses zwischen der Spitze eines RTM oder RKM und der betreffenden Festkörperoberfläche erzeugt wird.

6. Verfahren gemäß Anspruch 4, dadurch gekennzeichnet, daß die chemische Reaktion dadurch bewirkt wird, daß das räumlich und zeitlich begrenzte elektrische Feld unter gleichzeitiger Einstrahlung von Licht angelegt wird.

7. Verfahren gemäß Anspruch 1, dadurch gekennzeichnet, daß als Festkörperoberfläche ein halbleitendes Schichtmaterial eingesetzt wird.

8. Verfahren gemäß Anspruch 1, dadurch gekennzeichnet, daß die chemische Reaktion der Festkörperoberfläche mit Atomen und Molekülen einer die Festkörperoberfläche umgebenden Gasphase stattfindet.

9. Verfahren gemäß Anspruch 1, dadurch gekennzeichnet, daß eine chemische Reaktion mit Atomen oder Molekülen erfolgt, die an der Festkörperoberfläche adsorbiert sind.

10. Verfahren zur Abbildung der gemäß einem der Ansprüche 1 bis 9 erhaltenen Markierungen mit Hilfe einer oberflächensensitiven Rastersonde.

11. Verfahren zur Beseitigung der gemäß einem der Ansprüche 1 bis 9 erhaltenen Markierungen durch Zufuhr thermischer Energie, Einwirkung elektromagnetischer Strahlung oder chemische Behandlung der Oberfläche.

12. Verwendung des Verfahrens zur zeitlich stabilen Markierung einzelner Atome oder Atomgruppen gemäß einem der Ansprüche 1 bis 9 zur Speicherung von Informationseinheiten im atomaren Bereich.

13. Verwendung des Verfahrens gemäß Anspruch 11 zum Löschen von gemäß Anspruch 1 gespeicherten Informationseinheiten.

Abb. 1

Abb. 2